# EUROPEAN PATENT SPECIFICATION

(11) **EP 4 216 259 B1**
(45) Date of publication and mention of the grant of the patent: **15.05.2024**
(21) Application number: 22152939.9
(22) Date of filing: 24.01.2022
(51) Int. Cl.: H01L 21/60, H01L 23/495, H01L 25/11

(54) **SEMICONDUCTOR DEVICE, SEMICONDUCTOR MODULE AND MANUFACTURING METHOD**
HALBLEITERBAUELEMENT, HALBLEITERMODUL UND HERSTELLUNGSVERFAHREN
DISPOSITIF À SEMI-CONDUCTEUR, MODULE À SEMI-CONDUCTEUR ET PROCÉDÉ DE FABRICATION

(43) Date of publication of application: 26.07.2023
(73) Proprietor: Hitachi Energy Ltd, 8050 Zürich (CH)
(72) Inventor: SCHUDERER, Juergen, 8047 Zürich (CH); SALVATORE, Giovanni, 34170 Gorizia (IT); MOHN, Fabian, 5408 Ennetbaden (CH); LIU, Chunlei, 5452 Oberrohrdorf (CH)
(74) Representative: Epping - Hermann - Fischer

(56) References cited:
- EP-A1- 3 534 394
- DE-A1-102015 115 999
- DE-U1-202011 110 547
- US-A1- 2010 078 783
- US-B2- 8 975 732

## Description

A semiconductor device and a semiconductor module comprising such a semiconductor device are provided. A method for manufacturing such a semiconductor device is also provided. Document EP 2 988 328 A1 refers to a power semiconductor module.

Document DE 10 2014 218 240 A1 discloses a power device integrated in a printed circuit board.

Document DE 10 2015 115 999 A1 describes a semiconductor device comprising: a semiconductor chip configured for voltages of at least 0.6 kV comprising top contact areas at a chip top side, a first electric wiring layer in electric contact with the top contact areas having first contact areas electrically assigned to the top contact areas, a second electric wiring layer on a side of the first electric wiring layer remote from the top contact areas and having second contact areas electrically assigned to the top contact areas, the second contact areas are configured as external contact areas, and at least one third electric wiring layer located between and electrically connected with the first electric wiring layer and the second electric wiring layer and having third contact areas. The semiconductor device is a chip-sized package.

The semiconductor chip is a power insulated-gate bipolar transistor, IGBT. The first, second and third wiring layers are separated from one another in each case by an insulation layer made of a dielectric material through which electric through-contacts are formed.

Documents US 2010/0078789 A1, US 8 975 732 B2, DE 20 2011 110 547 U1 and EP 3 534 394 A1 refer to semiconductor devices.

A problem to be solved is to provide a semiconductor device that can be used at comparably high voltages.

This object is achieved by a semiconductor device, by a semiconductor module and by a method as defined in the independent patent claims. Exemplary further developments constitute the subject-matter of the dependent claims.

The semiconductor device comprises at least one intermediate electric wiring layer in an insulation body, the at least one intermediate electric wiring layer is located between chip top contact areas of a semiconductor chip and second contact areas for externally contacting the semiconductor device.

By means of the at least one intermediate electric wiring layer, a shape of the second contact areas can be designed independent of a shape of the chip top contact areas. Further, a distance between the chip top contact areas and outer faces of the semiconductor device can be increased. Hence, the semiconductor device can be provided with high voltages and the second contact areas can be designed in manifold manners for electrically connecting the semiconductor device.

The semiconductor device is, for example, a power device to convert direct current from a battery to alternating current for an electric motor, for example, in vehicles like hybrid vehicles or plug-in electric vehicles or also in railways, like commuter trains.

The semiconductor chip and, thus, the semiconductor device, is configured for a maximum voltage of at least 0.6 kV or of at least 1.2 kV or of at least 1.6 kV. Additionally, the semiconductor chip and, thus, the semiconductor device, may be configured for a maximum current of at least 1 A or of at least 20 A or of at least 50 A; the maximum current may be at most 1000 A or at most 200 A.

The first electric wiring layer is the electric wiring layer being next to the chip top side. Between the chip top side and the first electric wiring layer, there is a plurality of electric insulation layers. Through said insulation layer, electric through-contacts contact the top contact areas of the semiconductor chip with the first contact areas. The first contact areas can be a structured metallization layer applied on the at least one electric insulation layer.

Analogously, there are electric insulation layers between the first electric wiring layer and the second electric wiring layer, wherein electric through-contacts run through the electric insulation layers. The second electric wiring layer is a topmost electric wiring layer applied on an outer face of the semiconductor device. For example, the second electric wiring layer is a further structured metallization layer applied on the topmost electric insulation layer. Hence, the second electric wiring layer is the electric wiring layer most remote from the chip top side. By means of the second contact areas, the semiconductor device can be externally contacted, for example, to a circuit board.

At least one or some or all of the second contact areas are shaped differently from the respectively assigned one of the top contact areas, seen in top view of the chip top side. It is also possible that at least one or some or all of the second contact areas are shaped differently from the respectively assigned one of the first contact areas.

The semiconductor device further comprises one or a plurality of third electric wiring layers. The at least one third electric wiring layer is located between the first electric wiring layer and the second electric wiring layer. Moreover, the at least one third electric wiring layer is electrically connected with the first electric wiring layer and the second electric wiring layer, respectively, in particular by means of electric through-contacts running through adjacent additional insulation layers. The at least one third electric wiring layer comprises third contact areas which are formed, for example, by at least one additional structured metallization layer.

According to at least one embodiment, if there are N third electric wiring layers, there is a sequence: top contact areas of the semiconductor chip - insulation layer having electric through-contacts - first contact areas of the first electric wiring layer - N times (insulation layer having electric through-contacts - third contact areas of the third electric wiring layer) - insulation layer having electric through-contacts - second contact areas of the second electric wiring layer, wherein N is a natural number equal to one or greater than one. In particular N = 1 or N = 2 or N = 3. For example, it applies that 1 ≤ N ≤ 20 or 1 ≤ N ≤ 5 or 2 ≤ N ≤ 5.

For example, there is exactly one electric insulation layer between each one of the electric wiring layers as well as between the top contact areas and the first electric wiring layer.

According to at least one embodiment, staring from the top contact areas or from the first contact areas and towards the second contact areas, a shape of the respectively assigned contact areas becomes more similar to the second contact areas, for example, from third electric wiring layer to third electric wiring layer and finally towards the second contact areas. Hence, a shape of the intermediate electric wiring layers can gradually change to approximate the second contact areas.

According to at least one embodiment, the number of top contact areas it the same as the number of contact areas in each one of the electric wiring layers. In other words, the number of contact areas does not change from the chip to the second contact areas. For example, beginning from the top contact areas and up to the second contact areas, from electric wiring layer to electric wiring layer, there can be a one-to-one assignment of contact areas. For example, the contact areas of one wiring layer are electrically connected with the contact areas of the adjacent wiring layer in each case by means of one or a plurality of the electric through-contacts. The same applies with respect to the top contact areas and the first contact areas.

According to at least one embodiment, a thickness of the insulation layers between the wiring layers and also between the top contact areas and the first wiring layer is in each case at most 200 µm or at most 120 µm. Alternatively or additionally, said thickness is at least 10 µm or at least 50 µm or at least 80 µm.

According to at least one embodiment, at least one or some or each one of the wiring layers comprises one, two or more than two of the contact areas.

It is possible that the contact areas of the different wiring layers are assigned to each other according to their size. For example, the largest top contact area is assigned to the largest first contact area, to the largest second contact area and, if present, to the largest third contact area, and the smallest top contact area is assigned to the smallest first contact area, to the smallest second contact area and, if present, to the smallest third contact area, and so on. Said assignments can be one-to-one assignments.

For example, the smallest top contact area as well as the smallest second contact area are gate contacts. 'Small' and 'large' refer, for example, to an area content of the respective contact area, that is, for example, the size of an area a respective metallization is applied on.

According to at least one embodiment, at least one of the second contact areas overlays with any one of the top contact areas for at most 20% or for at most 10% or for at most 5% of a size of the respective second contact area, seen in top view of the chip top side. That is, the respective second contact area and the assigned top contact area does not significantly overlap, seen in top view. This may apply for exactly one of the second contact areas or for some of the second contact areas or for all of the second contact areas.

According to at least one embodiment, said at least one of the second contact areas is located completely outside of the respective top contact area, seen in top view of the chip top side. That is, the respective second contact area and the assigned top contact area disjunct and therefore does not overlap at all, seen in top view. This may apply for exactly one of the second contact areas or for some of the second contact areas or for all of the second contact areas.

A first one of the second contact areas completely runs around a second one of the second contact areas, seen in top view of the chip top side. Thus, seen in top view, the second one of the second contact areas can be completely surrounded by the first one of the second contact areas.

That is, the first one of the second contact areas runs coaxially around the second one of the second contact areas. Hence, the respective second contact areas are arranged in a rotational and/or point symmetric manner, seen in top view. With such a coaxial design, low parasitic inductances can be achieved as well as improved shielding and controlled stray capacitances.

For example, the first one of the second contact areas is a frame around the second one of the second contact areas and can be a source or emitter external contact pad. For example, the first one of the second contact areas is the largest one of the second contact areas. Consequently, the second one of the second contact areas can be the smallest external contact pad and may be a gate contact pad.

Thus, by means of the first one and the second one of the second contact areas different external electric contact areas of the semiconductor device can be realized.

According to at least one embodiment, the top contact area assigned to the second one of the second contact areas is located at an edge of the chip top side, seen in top view of the chip top side. Thus, the top contact areas are arranged in a non-point symmetric manner while the second contact areas can be arranged in a point symmetric manner.

According to at least one embodiment, the top contact areas are arranged in a symmetric manner. For example, there is one or there are two axes of mirror symmetry concerning the top contact areas, seen in top view of the chip top side. As an alternative, the top contact areas can be arranged in a non-symmetric manner, that is, in particular without any mirror symmetry or point symmetry.

According to at least one embodiment, the semiconductor device is a chip-sized package. This may mean that an overall size of the semiconductor device is at most 130% or at most 120% of a size of the chip top side, seen in top view of the chip top side. Alternatively or additionally, this may mean that the semiconductor device comprises the exactly one semiconductor chip.

According to at least one embodiment, an overall size of all the second contact areas together is larger than an overall size of the top contact areas or of the size of the chip top side. Thus, by having the at least one intermediate wiring layer, a fan-out and/or expansion of the top contact areas towards the second contact areas can be achieved.

According to at least one embodiment, a thickness of the electric wiring layers and/or of the top contact areas is in each case at least 1 µm or at least 20 µm or at least 40 µm.

Alternatively, said thickness is at most 200 µm or at most 100 µm. It is possible that the top contact areas are thinner than the first and third contact areas and that the second contact areas are thicker than the first and third contact areas.

According to at least one embodiment, a diameter of the electric through-contacts is in each case between 20 µm and 200 µm inclusive. For example, said diameter is about 0.1 mm.

A semiconductor module is additionally provided. The semiconductor module comprises a semiconductor device as indicated in connection with at least one of the above-stated embodiments. Features of the semiconductor module are therefore also disclosed for the semiconductor device and vice versa.

The semiconductor module comprises one or a plurality of the semiconductor devices and an electric carrier. The second contact areas are connected with at least one of electric contact faces or thermal contact faces of the electric carrier.

A method for manufacturing the semiconductor device is additionally provided. By means of the method, a semiconductor device is produced as indicated in connection with at least one of the above-stated embodiments. Features of the semiconductor device are therefore also disclosed for the method and vice versa.

With the semiconductor device and the semiconductor module described herein, a shape of the top contact areas does not need to correspond to a shape of external electric contact areas, like the second contact areas. Thus, it is possible to design the top contact areas for optimized semiconductor chip properties, while the second contact areas as well as the intermediate contact areas can be designed quite independently according to the specific requirements of an application scenario, like available physical space. Thus, geometric considerations as well as electrical considerations, concerning, for example, voltage, current and insulation, and thermal considerations, like heat conduction and heat interface, can be taken into account simultaneously. For example, with a coaxial design of the second contact areas, low parasitic inductances can be achieved as well as improved shielding, increased controlling of stray capacitances, and/or reduced stray inductances. Hence, by having at least one of the second contact areas of a different shape compared with the assigned one of the top contact areas, multi-aspect optimization can be achieved which is not possible without intermediate first and possibly third electric wiring layers.

A semiconductor device, a semiconductor module and a method described herein are explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist in understanding.

In the figures:
- Figure 1: is a schematic top view of a modified semiconductor device not covered by the claims,
- Figure 2: is a schematic sectional view of the semiconductor device of Figure 1,
- Figure 3: is a schematic sectional view of an illustrative example of a semiconductor device described herein not covered by the claims,
- Figure 4: is a schematic top view perpendicular of the semiconductor device of Figure 3,
- Figures 5 to 7: are schematic top views of illustrative examples of semiconductor devices not covered by the claims,
- Figures 8: and 9 are schematic top views of exemplary embodiments of semiconductor devices described herein which falls within the scope of the claimed invention,
- Figures 10 and 11: are schematic sectional views of illustrative examples of semiconductor devices not covered by the claims,
- Figure 12: is a schematic sectional view of an exemplary embodiment of a semiconductor device described herein which falls within the scope of the claimed invention,
- Figures 13 to 15: are different schematic sectional views of illustrative examples of semiconductor device described herein not covered by the claims,
- Figure 16: is a schematic sectional view of an exemplary embodiment of a semiconductor device described which does fall within the scope of the claimed invention,
- Figure 17: is a schematic side view of an exemplary embodiment of a semiconductor module comprising semiconductor devices described herein, and
- Figure 18: is a schematic block diagram of an exemplary embodiment of a method to manufacture semiconductor devices described herein.

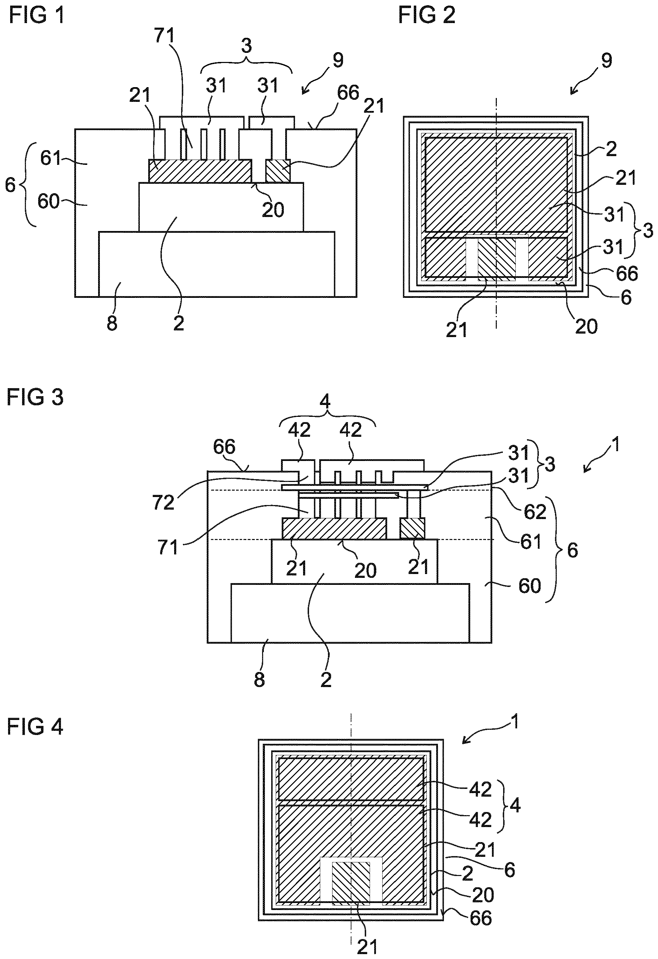

In Figures 1 and 2, a modified semiconductor device 9 not covered by the claims is illustrated. The modified semiconductor device 9 comprises a semiconductor chip 2 which is embedded in an insulation body 6. At a chip top side 20, the semiconductor chip 2 comprises top contact areas 21. In a lateral direction, that is, in a direction in parallel with the chip top side 20, the semiconductor chip 2 is embedded in an insulation embedding 60 of the insulation body 6.

Starting from the top contact areas 21, first electric through-contacts 71 rung through a first insulation layer 61 of the insulation body 6. By means of the through-contacts 71, the top contact areas 21 are electrically connected with first contact areas 31 of a first electric wiring layer 3 at a body top side 66 of the insulation body 6. As an option, the semiconductor chip 2 is applied on a substrate 8, lateral faces of the substrate 8 can be in contact with the insulation body 6.

Chip-scale packaging, CSP for short, originates from conventional printed circuit board, PCB, manufacturing and has been originally conceived for the integration of miniaturized and heterogeneous microelectronic and/or optical components, also referred to as System in Package, SiP, mostly for consumer electronics. However, such packages as illustrated in Figure 1 are not compatible with high electric voltages above, for example, 0.6 kV.

Chip-scale packaging may offer various advantages over TO-like, QFN and other surface mounted packages, like improved heat extraction, no-wire bonding, lower parasitics, and may provide an alternative route to the assembly of power modules, like cleanroom-less assembly. Another key advantage of such embedded solutions is the design freedom to fan-out contact areas, also referred to as bond pads, and to integrate multi-layer signal routing of any shape and complexity as needed. This can allow to realize low-inductance interconnects, to integrate sensors and controllers with a multitude of I/O channels, and to realize ultra-compact packages without the need of wire bonds leading to flat layouts and/or geometries beneficial also for double side-cooling designs. Finally, the development of such a technology may impact the current semiconductor-power module value chain: chip manufacturers could adopt the technology and disrupt the current state of the art in the design and assembly of power modules.

One evident advantage of CSP is that it enables the chip pad contacts to be fanned-out. However, in a one-metal prepackage, as shown in Figure 1, the fan-out layout is constrained by the layout of the chip contact pads, that is, of the top contact areas 21. For example, the CSP top metallization must overlap with the chip contact pads. So, the layout of the CSP top metallization cannot be arbitrary which would be desirable to be fully flexible in the arrangement of the CSP component when design a power module. Moreover, the enlargement, for example, of a gate contact pad usually comes at the expenses of reducing a drain/emitter contact area, and hence, reducing the current capability of the semiconductor chip.

To overcome these restrictions, the semiconductor device 1 described herein comprises at least one intermediate wiring layer located between the top contact areas 21 and a topmost second electric wiring layer 4, compare Figures 3 and 4 which do not fall within the scope of the claimed invention, but which are useful for understanding the invention.

Thus, a multi-layer prepackage is used to produce a CSP component with arbitrary top-metallization layout. This may be done by multiple embedding and lamination steps. Such a solution achieves the desired fan-out without reducing an active area of the semiconductor chip 2, and, hence, without reducing its current capability.

For high voltage applications, the encapsulant thickness and, in case of a multi-layer structure, each insulating layer should be properly designed to withstand the blocking voltage. Such requirements may be relaxed if the inner and top metal pad do not cross the termination area of the chip and the component is further encapsulated.

Thus, a semiconductor device 1 is provided which comprises a semiconductor chip 2 configured for voltages of at least 0.6 kV, the semiconductor chip 2 has the top contact areas 21 on the chip top side 20, and a plurality of electric through-contacts 71, 72, 73 are electrically connected with the top contact areas 21. The semiconductor chip 2 and the electric through-contacts 71, 72, 73 are embedded in the electrically insulating insulation body 6, wherein the electric through-contacts 71, 72, 73 run through the insulation body 6 in the direction away from the chip top side 20. At least one intermediate wiring 3, 5 is present at side of the top contact areas 21 remote from the semiconductor chip 2 and in electric contact with the electric through-contacts 71, 72, 73.

The wiring layers 3, 4, 5 are design to avoid short any circuit between the top contact areas, also referred to as chip terminations, like gate-source-drain.

According to Figures 3 and 4, atop the top contact areas 21 there is the first insulation layer 61 on which the first electric wiring layer 3 is applied. Said first electric wiring layer 3 is followed by a second insulation layer 62 on which a second electric wiring layer 4 having second electric contact areas 42 is applied. It is possible that the second contact areas 42 of the second electric wiring layer 4 are the only contact areas at the body top side 66 emerging from the insulation body 6. However, as an option, the semiconductor chip 2 can be electrically contacted to the substrate 8 which is, for example, a leadframe based on copper. Thus, the only parts emerging from the insulation body 6 may be the substrate 8 and the second contact areas 42.

Figure 3 illustrates a sectional view along the dash-dotted line in Figure 4. According to Figures 3 and 4, the smaller one of the rectangular second contact areas 42 is connected with the smaller ones of the top contact areas 21, but, seen in top view, does not overlap with said top contact area 21. This is enabled by means of the first electric wiring layer 3 located within the insulation body 6 which provides a current path in parallel with the chip top side 20. Thus, a shape of the second contact areas 42 is largely independent of a shape of the top contact areas 21.

For example, the semiconductor chip 2 is a power MOSFET or a power IGBT configured for a current of at least 10 A and/or of at most 100 A. Alternatively or additionally, the semiconductor chip 2 and, thus, the semiconductor device 1 is configured for a voltage of at least 1.2 kV or of at least 1.5 kV.

As an option, the larger one of the top contact areas 21 is shaped like a U or a U, seen in top view. The smaller one of the top contact areas 21 is located between the legs of the U or U. The arrangement of the top contact areas 21 can have at least one axis of mirror symmetry, for example. In Figure 4, the top contact areas 21 are symbolized as shaded areas, wherein the semiconductor chip 2 is also schematically illustrated for improved understanding; however, the intermediate wiring layer 3 is not illustrated in Figure 4.

For example, the chip top side 20 has a size of at least 5 mm x 5 mm and/or of at most 15 mm x 15 mm. Alternatively or additionally, a thickness of the semiconductor chip 2 perpendicular to the chip top side 20 is at least 100 µm and/or at most 1 mm, for example, between 300 µm and 500 µm.

For example, the electric through-contacts 71, 72, 73 are metalized holes or also metal blocks. Per contact area 21, 31, 42, 53, there can be only one or a plurality of the electric through-contacts 71, 72, 73, in particular depending on the size and the current the respective contact area 21, 31, 42, 53 is configured for. If the through-contacts 71, 72, 73 are metalized holes, then a diameter of the through-contacts 71, 72, 73 is, for example, between 50 µm and 200 µm; if the through-contacts 71, 72, 73 are metal blocks, then the through-contacts 71, 72, 73 can have larger lateral extents. Such metal blocks can be bonded, like sintered or soldered, to the corresponding contact areas 21, 31, 42, 53.

A height of the through-contacts 71, 72, 73 may correspond to a height of the associated insulation layer 61, 62, 63, 65. For example, the through-contacts 71, 72, 73 are made of copper or a copper alloy.

Although the semiconductor device of Figures 3 and 4 which is not covered by the claims comprises two top contact areas 21 and, thus, two contact areas 31, 42 in each one of the electric wiring layers 3, 4, there can alternatively be only one top contact area 21 and, thus, only one contact area 31, 42 in each one of the electric wiring layers 3, 4, or there are at least three top contact areas 21 and, thus, at least three contact areas 31, 42 in each one of the electric wiring layers 3, 4. Furthermore, it is not strictly required that the number of top contact areas 21 is the same as the number of contact areas 31, 42 in each one of the electric wiring layers 3, 4, although this is preferred. In addition to the electric contact areas 21, 31, 42, as an option there can be thermal contact areas, not illustrated, to improve cooling, said thermal contact areas do not need to have any electric function. These aspects can apply, in any combination, also in all other embodiments.

Otherwise, the same as to Figures 1 and 2 may also apply to Figures 3 and 4, and vice versa.

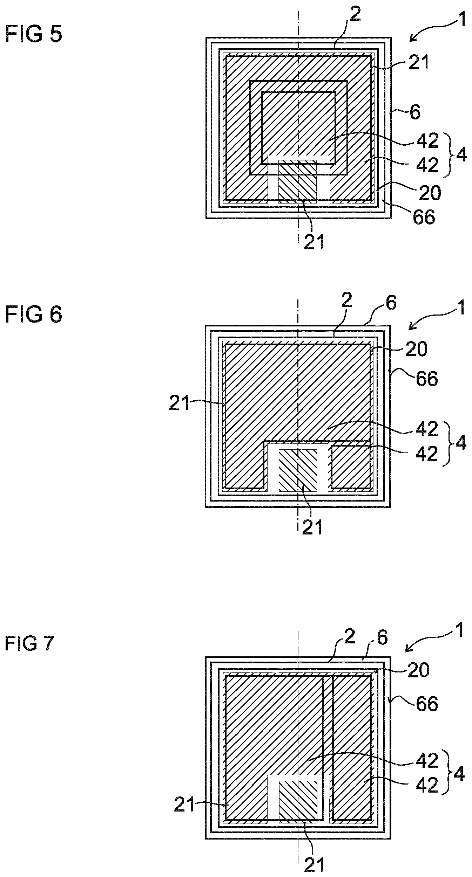

In Figure 5, another illustrative example of the semiconductor device 1 is illustrated, which does not fall within the scope of the claimed invention, analogously to Figure 4. According to Figure 5, the second contact areas 42 are arranged in a coaxial manner. Hence, a first one of the second contact areas 42 completely runs around a second one of the second contact areas 42, seen in top view of the chip top side 20. Thus, the first one as well as the second one of the second contact areas 42 belong to the second electric wiring layer 4 and can be arranged in a common plane as external electric contact pads. Other than shown, there can be further second contact areas 42 of the second electric wiring layer 4 as external electric contact pads.

For example, the top contact area 21 assigned to the second one of the second contact areas 42 is located at an edge of the chip top side 20, and said contact areas 21, 42 may only marginally overlap. The top contact area 21 assigned to the first one of the second contact areas 42 may be of U or U shape, again seen in top view of the chip top side 20.

Seen in top view, there can be two or four axes of mirror symmetry concerning the shape of the second contact areas 42. For example, a track width of the outer, first one of the second contact areas 42 may correspond to at least 10% and/or to at most 40% of a maximum edge length of the chip top side 20. An edge length of the inner, second one of the second contact areas 42 is, for example, at least 20% and/or at most 60% of the maximum edge length of the chip top side 20. Otherwise, the same as to Figures 1 to 4 may also apply to Figure 5, and vice versa.

According to Figure 6, which does not fall within the scope of the claimed invention, a larger, third one of the second contact areas 42 is of L-shape, and a smaller, fourth one of the second contact areas 42 in of rectangular or square shape and is located in a cut-out of the third one of the second contact areas 42. seen in top view of the chip top side 20. For example, the fourth one of the second contact areas 42 is located in a corner of the second electric wiring layer 4. For example, the top contact areas 21 are shaped like in Figures 4 and 5. Thus, the smaller, fourth one of the second contact areas 42 may not overlap with the assigned smaller one of the top contact areas 21. Other than shown in Figure 6 it is also possible that the smaller one of the top contact areas 21 is partially or completely covered by the third one of the second contact areas 42.

Otherwise, the same as to Figures 1 to 5 may also apply to Figure 6, and vice versa.

According to Figure 7, which does not fall within the scope of the claimed invention, a fifth one and a sixth one of the second contact areas 42 are of rectangular shape and may run in parallel with one another, seen in top view of the chip top side 20. Said second contact areas 42 can have different sizes. For example, the top contact areas 21 are shaped like in Figures 4 to 6.

The larger top contact area 21 assigned to the fifth one of the second contact areas 42 may thus be of U or U shape and can be located next to all four edges of the chip top side 20, and the top contact area 21 assigned to the sixth one of the second contact areas 42 is located outside the sixth one of the second contact areas 42, also seen in top view of the chip top side 20. Hence, the sixth one of the second contact areas 42 and the assigned top contact area 21 do not overlap or overlap only marginally.

As in all the other embodiments, an overall size of all second contact areas 42 together can be larger than the size of the chip top side 20.

Otherwise, the same as to Figures 1 to 6 may also apply to Figure 7, and vice versa.

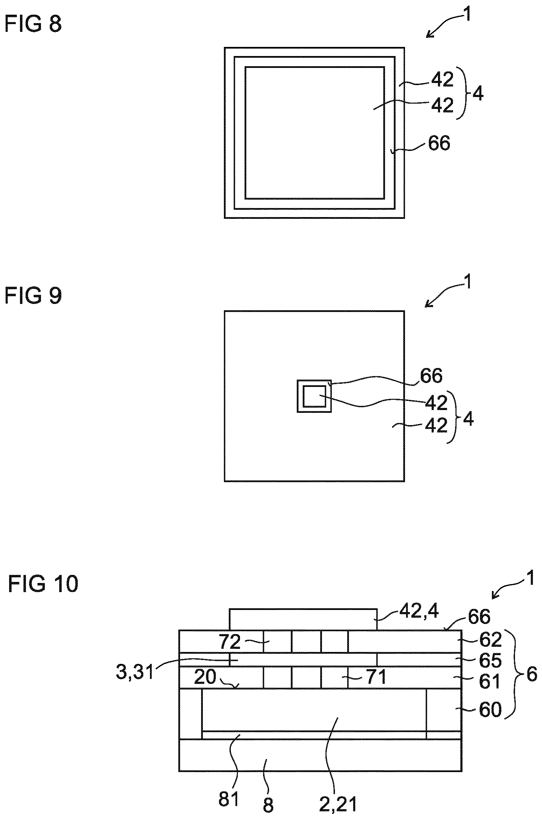

In Figure 8, which does fall within the scope of the claimed invention, it is shown that the central, second one of the second contact areas 42 is the largest one of the second contact areas 42. The second one of the second contact areas 42 is, for example, an emitter pad or a source pad, and correspondingly the circumferential first one of the second contact areas 42 has an overall smaller area content and may be a gate contact pad. For example, a track width of the outer, first one of the second contact areas 42 may correspond to at least 2% and/or to at most 15% of the maximum edge length of the chip top side 20. An edge length of the inner, second one of the second contact areas 42 is, for example, at least 60% and/or at most 95% of the maximum edge length of the chip top side 20.

For example, the top contact areas 21 are shaped like in Figures 4 to 8. The second one of the second contact areas 42 may be of square shape, seen in top view.

Otherwise, the same as to Figures 1 to 7 may also apply to Figure 8, and vice versa.

According to Figure 9, which does fall within the scope of the claimed invention, the inner second one of the second contact areas 42 is comparably small and amounts, for example to at most 10% or 5% of an overall size of the semiconductor device 1, seen in top view. Hence, the circumferential first one of the second contact areas 42 can cover nearly the whole body top side 66. For example, the inner second one of the second contact areas 42 is a gate contact pad. In this coaxial design, by putting the gate contact pad in the middle, the outer, layer contact area 42 which is, for example, a emitter or source contact pad, can be maximized for a low parasitic inductance. The same can also apply to all intermediate wiring layers 3, 5.

It is possible that the second one of the second contact areas 42 does not overlap with the assigned top contact area 21, seen in top view.

Otherwise, the same as to Figure 8 may also apply to Figure 9, and vice versa.

In the embodiment of Figure 10, which does not fall within the scope of the claimed invention, it is illustrated that all the first contact areas 31 of the first electric wiring layer 3 are located in a common plane atop the first insulation layer 61. Further, as an option, around the first contact areas 31 in the lateral direction there is a further insulation layer 65. Hence, the further insulation layer 65 is located between the first insulation layer 61 and the second insulation layer 62.

According to Figure 10, the substrate 8 is not embedded into the insulation body 6, but lateral faces of the substrate 8 can be free of the insulation body 6. The substrate 8 is connected to the semiconductor chip by means of a connection means 81, like a solder. The substrate 8 is, for example, a heat sink or a leadframe. Such a configuration can also be present in all other embodiments. It is noted that for simplifying the drawing, in Figure 10 only one of the contact areas 31, 42 is explicitly illustrated.

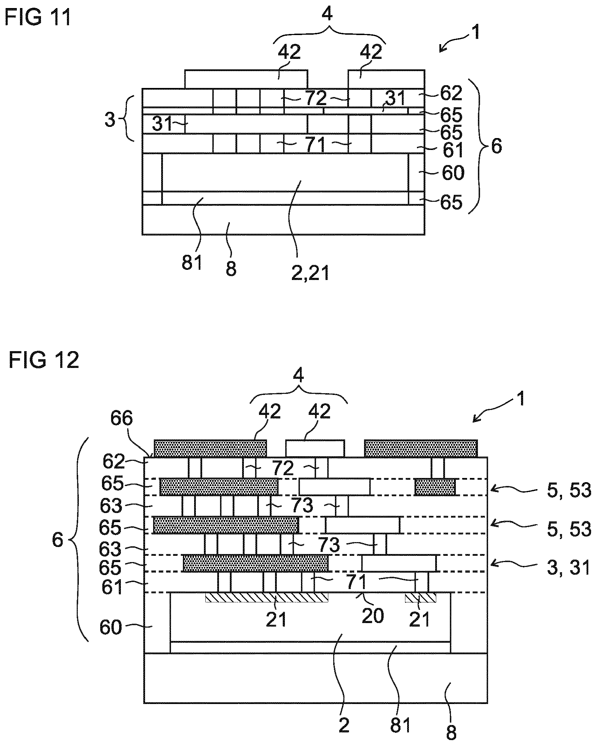

Contrary to what is shown in Figure 10, according to Figure 11, which does not fall within the scope of the claimed invention, the first contact areas 31 assigned to different top contact areas 21 are not located within one plane, but are offset in the direction perpendicular to the chip top side 20. Thus, there can be two further insulation layers 65 on top of each other, each one assigned to one of the first contact areas 31. As an additional option, there can be a further insulation layers 65 assigned to the connection means 81 as well.

Otherwise, the same as to Figures 1 to 9 may also apply to Figures 10 and 11, and vice versa.

In Figure 12, which does fall within the scope of the claimed invention, it is illustrated that the semiconductor device 1 comprises more than one intermediate layer, that is, in addition to the first electric wiring layer 3 there is at least one third electric wiring layer 5 located between the first electric wiring layer 3 and the second electric wiring layer 4. In the example of Figure 12, there are two of the third electric wiring layers 5 on top of each other, however, it is also possible that there is only one third electric wiring layer 3 or that there are at least three of the third electric wiring layers 5.

In Figure 12 the intermediate wiring layers 3, 4 are configured like in Figure 10 so that all of the contact areas 31, 53 of a specific wiring layer 3, 4 are located in a common plane. However, the configuration according to Figure 11 is possible as well so that the contact areas 31, 53 within one of the first and third wiring layers 3, 4 can be displaced in the direction perpendicular to the chip top side 20.

Such at least one third electric wiring layer 5 can also be present in all other embodiments.

Moreover, as an option the intermediate electric wiring layers 3, 5 can have patterns of contact areas 31, 53 that differ from one another. Hence, beginning with the top contact areas 21, the respectively assigned contact areas 31, 53 are shaped more like the respectively assigned second contact area 42 the closer the respectively assigned contact area 31, 53 comes to the relevant second contact area 42.

It is possible that metallizations for the intermediate wiring layers 3, 5 are thinner than for the topmost second electric wiring layer 4. For example, a thickness of the first and/or third contact areas 31, 53 is between 30 µm and 70 µm while a thickness of the second contact areas 42 is between 80 µm and 200 µm. The same is possible in all other embodiments.

Otherwise, the same as to Figures 1 to 11 may also apply to Figure 12, and vice versa.

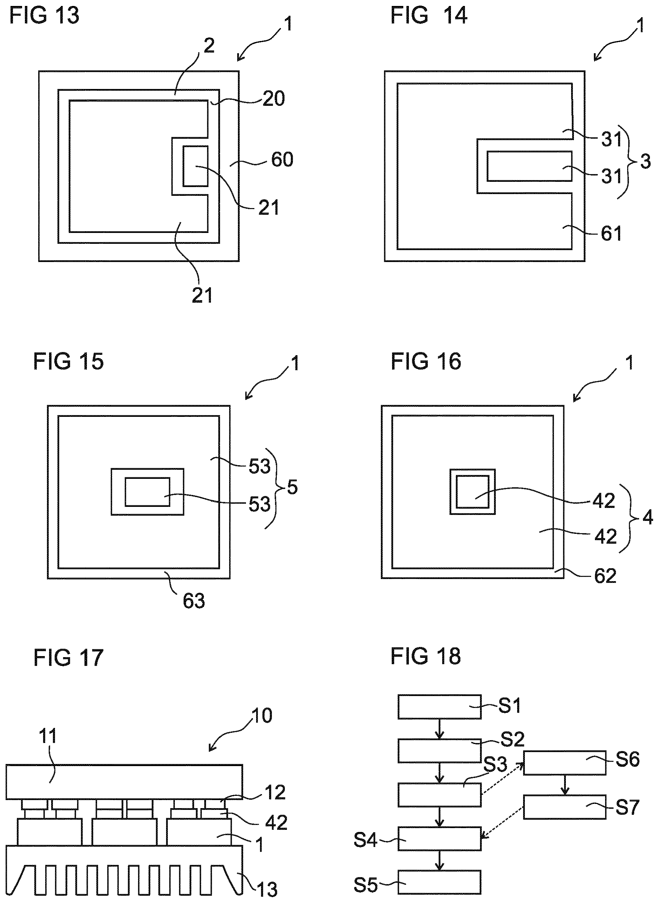

In Figures 13 to 16, another embodiment of the semiconductor device 1 is illustrated by means of cross-sectional views. In this case, the semiconductor device 1 comprises one third electric wiring layer 5. Similar to the embodiment of Figure 12, the intermediate layers 3, 5 have different shapes so that a more gradual change of the shape of the top contact areas 21 towards the shape of the second contact areas 42 can be achieved.

Hence, the top contact areas 21, see Figure 13, which does not fall within the scope of the claimed invention, can be shaped like in Figures 5 to 7, for example. Then, see Figure 14, which does not fall within the scope of the claimed invention, the smaller one of the first contact areas 31 of the first electric wiring layer 3 extends towards a center of the semiconductor device 1, compared with Figure 13.

Next, see Figure 15, which does not fall within the scope of the claimed invention, the smaller one of the third contact areas 53 is shifted to the center, compared with Figure 14, and the larger one of the third contact areas 53 surrounds the smaller one of the third contact areas 53. However, the smaller one of the third contact areas 53 is still arranged off-center. Finally, see Figure 16, which does fall within the scope of the claimed invention, the smaller one of the third contact areas 53 is surrounded by the larger one of the third contact areas 53 in a symmetric manner. Such a gradual change of the shape of the contact areas towards the shape of the second contact areas 42 can also be present in all other examples and embodiments.

Otherwise, the same as to Figures 1 to 12 may also apply to Figures 13 to 16, and vice versa.

In Figure 17, falling within the scope of the claimed invention, a semiconductor module 10 is illustrated. The semiconductor module 10 comprises one or a plurality of the semiconductor devices 1 as shown, for example, in any one of Figures 1 to 16. The semiconductor module 10 further comprises an electric carrier 11 like a circuit board. The electric carrier 11 has contact faces 12 to which the second contact areas 42 are attached, for example, by means of soldering or sintering.

It is possible that the contact faces 12 and the assigned second contact areas 42 are of the same size, see the middle one of the semiconductor devices 1, or also that the contact faces 12 are larger or smaller than the assigned second contact areas 42, see the left and right one of the semiconductor devices 1, respectively.

As a further option, the semiconductor module 10 comprises a cooler 13. The cooler 13 can be attached to the substrate 8 of the at least one semiconductor device 1. Thus, it is possible to provide heat sinks on both main sides of the at least one semiconductor device 1 to improve cooling and to allow higher currents to be handled.

Finally, see Figure 18, a method for producing the semiconductor devices is schematically illustrated.

In a first method step S1, the semiconductor chip 1 having the top contact areas 42 is provided. In this step, for example, the optional insulation embedding 60 is already present.

Then, in method step S2, the first insulation layer 31 is provided and the first electric through-contacts 71 are created.

In method step S3, the first electric wiring layer 3 is formed, wherein the first contact areas 31 can all be in the same plane, compare Figure 10, or the first contact areas 31 are formed one after the other by using the further insulation layer 65, compare Figure 11. A thickness of the further insulation layer 65 corresponds to a thickness of the associated first contact area 31, for example.

In method step S4, the second insulation layer 62 is provided and the second electric through-contacts 72 are formed. If the further insulation layer 65 is present, then the second electric through-contacts 72 may also run through the further insulation layer 65.

Then, in method step S5 the second contact areas 42 are formed, for example, by means of plating.

There are method steps S6 and S7 performed between method steps S3 and S4. In method step S6, the third insulation layer 63 is formed and is provided with the third electric through-contacts 73. In method step S7, the third electric wiring layer 5 is provided. Method steps S6 and S7 can be repeated various times corresponding to the number of third electric wiring layers 5.

Thus, the CSP semiconductor device 1 is manufactured, for example, by a series of steps:
i) Bonding, like sintering, the semiconductor chip onto the substrate 8 like a copper leadframe,
ii) embedding the semiconductor chip 1 and optionally the substrate 8 by lamination with copper foil and/or prepreg and cutting the prepreg, or performing epoxy compression molding as an alternative process,
iii) forming the electric through-contacts by means of via drilling, for example,
iv) copper electroplating and structuring to produce the respective electric wiring layer.

The thickness of the prepreg foils would define the maximum voltage that the CSP can withstand. Standard materials are FR4 and epoxy, which have a breakdown field of about 2 kV per 100 µm. Including safety margins, the proper embedding of a 1.2 kV semiconductor device 1 would typically require a 100 µm thick insulation layer 61, 62, 63, 65 between the semiconductor chip 1 and a topside layer on source or gate potential. However, technological limitations, i.e. lamination and drilling of thick or multi-layer insulating layers, and conformal plating for such deep via structures have hindered the scaling of CSP to voltages higher than, for example, 0.6 kV. By means of the multi-layer structure of the semiconductor device 1 presented herein, higher voltages can be achieved due to increased insulation layer thickness, for example.

The components shown in the figures follow, unless indicated otherwise, preferably in the specified sequence directly or indirectly one on top of the other. Layers which are not in contact in the figures are preferably spaced apart from one another. If lines are drawn parallel to one another, the corresponding surfaces are preferably oriented parallel to one another. Likewise, unless indicated otherwise, the positions of the drawn components relative to one another are correctly reproduced in the figures.

### Reference Signs

- 1: semiconductor device
- 2: semiconductor chip
- 20: chip top side
- 21: top contact area
- 3: first electric wiring layer
- 31: first contact area
- 4: second electric wiring layer
- 42: second contact area
- 5: third electric wiring layer
- 53: third contact area
- 6: insulation body
- 60: insulation embedding
- 61: first insulation layer
- 62: second insulation layer
- 63: third insulation layer
- 65: further insulation layer
- 66: body top side
- 71: first electric through-contact
- 72: second electric through-contact
- 73: third electric through-contact
- 8: substrate
- 81: connection means
- 9: modified semiconductor device
- 10: semiconductor module
- 11: electric carrier
- 12: contact face
- 13: cooler
- S..: method step

## Claims

1. A semiconductor device (1) comprising:
- a semiconductor chip (2) configured for voltages of at least 0.6 kV comprising top contact areas (21) at a chip top side (20),
- a first electric wiring layer (3) in electric contact with the top contact areas (21) having first contact areas (31) electrically assigned to the top contact areas (21),
- a second electric wiring layer (4) on a side of the first electric wiring layer (3) remote from the top contact areas (21) and having second contact areas (42) electrically assigned to the top contact areas (31), the second contact areas (42) are configured as external contact areas, and
- at least one third electric wiring layer (5) located between and electrically connected with the first electric wiring layer (3) and the second electric wiring layer (4) and having third contact areas (53),
wherein
- the semiconductor device (1) is a chip-sized package,
- the semiconductor chip (2) is a power metal-insulator field-effect transistor, MISFET, or a power insulated-gate bipolar transistor, IGBT,
- the first, second and third wiring layers (3, 4, 5) are separated from one another in each case by an insulation layer (61, 62, 63) made of a dielectric material through which electric through-contacts (71, 72, 73) are formed,
- a first one of the second contact areas (42) shaped differently from an electrically assigned one of the top contact areas completely runs around a second one of the second contact areas (42) shaped differently from the electrically assigned one of the top contact areas in a coaxial manner, seen in top view of the chip top side (20), so that the first one and the second one of the second contact areas (42) are arranged rotational symmetrically and/or point symmetrically.

2. The semiconductor device (1) according to the preceding claim,
comprising at least two of the third electric wiring layers (5) located between and electrically connected with the first electric wiring layer (3) and the second electric wiring layer (4), respectively,
wherein, staring from the first contact areas (31) and towards the second contact areas (42), a shape of the respectively assigned third contact areas (53) becomes more similar to the second contact areas (42) from third electric wiring layer (5) to third electric wiring layer (5).

3. The semiconductor device (1) according to any one of the preceding claims,
wherein a thickness of the insulation layers (61, 62, 63) is in each case at most 100 µm.

4. The semiconductor device (1) according to any one of the preceding claims,
which an overall size of the semiconductor device (1) is at most 130% of a size of the chip top side (20), seen in top view of the chip top side (20), and so that the semiconductor device (1) comprises the exactly one semiconductor chip (2), wherein an overall size of all the second contact areas (42) together is larger than the size of the chip top side (20).

5. The semiconductor device (1) according to any one of the preceding claims,
wherein
- a thickness of the electric wiring layers (2, 3, 4) is in each case between 20 µm and 200 µm inclusive, and
- the electric through-contacts (71, 72, 73) run through each one of the insulation layers (61, 62, 63), the through-contacts (71, 72, 73) electrically connect adjacent ones of the electric wiring layers (3, 4, 5), and a diameter of the electric through-contacts (71, 72, 73) is in each case between 20 µm and 200 µm inclusive.

6. A semiconductor module (10) comprising
- at least one semiconductor device (1) according to any one of the preceding claims, and
- an electric carrier (11),
wherein the second contact areas (42) are connected with electric contact faces (12) of the electric carrier (11).

7. A method for manufacturing a semiconductor device (1) comprising
- providing a semiconductor chip (2) configured for voltages of at least 0.6 kV comprising top contact areas (21) at a chip top side (20),
- applying insulation layers (61, 62, 65) as well as a first electric wiring layer (3), a second electric wiring layer (4) and at least one third electric wiring layer (5) on the semiconductor chip (2),
wherein
- the semiconductor device (1) is a chip-sized package,
- the first electric wiring layer (3) is in electric contact with the top contact areas (21) having first contact areas (31) electrically assigned to the top contact areas (21),
- the second electric wiring layer (4) is on a side of the first electric wiring layer (3) remote from the top contact areas (21) and having second contact areas (42) electrically assigned to the top contact areas (31), the second contact areas (42) are configured as external contact areas,
- the at least one third electric wiring layer (5) is located between and electrically connected with the first electric wiring layer (3) and the second electric wiring layer (4) and having third contact areas (53),
- the semiconductor chip (2) is a power metal-insulator field-effect transistor, MISFET, or a power insulated-gate bipolar transistor, IGBT,
- the first, second and third wiring layers (3, 4, 5) are separated from one another in each case by one of the insulation layers (61, 62, 63) each made of a dielectric material through which electric through-contacts (71, 72, 73) are formed,
- a first one of the second contact areas (42) shaped differently from an electrically assigned one of the top contact areas completely runs around a second one of the second contact areas (42) shaped differently from the electrically assigned one of the top contact areas, seen in top view of the chip top side (20), so that the first one and the second one of the second contact areas (42) are arranged rotational symmetrically and/or point symmetrically.

## Patentansprüche

1. Halbleiterbauelement (1), Folgendes umfassend:
- einen Halbleiterchip (2), der für Spannungen von mindestens 0,6 kV eingerichtet ist und obere Kontaktflächen (21) an einer Chipoberseite (20) umfasst,
- eine erste elektrische Verdrahtungsschicht (3) in elektrischem Kontakt mit den oberen Kontaktflächen (21), die erste Kontaktflächen (31) aufweisen, die den oberen Kontaktflächen (21) elektrisch zugeordnet sind,
- eine zweite elektrische Verdrahtungsschicht (4) auf einer Seite der ersten elektrischen Verdrahtungsschicht (3), die von den oberen Kontaktflächen (21) entfernt ist und zweite Kontaktflächen (42) aufweist, die den oberen Kontaktflächen (31) elektrisch zugeordnet sind, wobei die zweiten Kontaktflächen (42) als externe Kontaktflächen eingerichtet sind, und
- mindestens eine dritte elektrische Verdrahtungsschicht (5), die zwischen der ersten elektrischen Verdrahtungsschicht (3) und der zweiten elektrischen Verdrahtungsschicht (4) angeordnet ist und mit diesen elektrisch verbunden ist und dritte Kontaktflächen (53) aufweist,
wobei
- das Halbleiterbauelement (1) eine chipgroße Packung ist,
- der Halbleiterchip (2) ein Metall-Isolator-Leistungsfeldeffekttransistor, MISFET, oder ein Bipolarleistungstransistor mit isoliertem Gate, IGBT, ist,
- die erste, die zweite und die dritte Verdrahtungsschicht (3, 4, 5) jeweils durch eine Isolationsschicht (61, 62, 63) voneinander getrennt sind, die aus einem dielektrischen Material angefertigt ist, durch das elektrische Durchkontakte (71, 72, 73) ausgebildet sind,
- eine erste der zweiten Kontaktflächen (42), die verschieden von einer elektrisch zugeordneten der oberen Kontaktflächen geformt ist, in Draufsicht auf die Chipoberseite (20) gesehen, vollständig um eine zweite der zweiten Kontaktflächen (42) herum verläuft, die in einer koaxialen Weise verschieden von der elektrisch zugeordneten der oberen Kontaktflächen geformt ist, so dass die erste und die zweite der zweiten Kontaktflächen (42) rotationssymmetrisch und/oder punktsymmetrisch angeordnet sind.

2. Halbleiterbauelement (1) nach dem vorhergehenden Anspruch,
mindestens zwei der dritten elektrischen Verdrahtungsschichten (5) umfassend, die zwischen der ersten elektrischen Verdrahtungsschicht (3) bzw. der zweiten elektrischen Verdrahtungsschicht (4) angeordnet sind und mit diesen elektrisch verbunden sind, wobei, von den ersten Kontaktflächen (31) und in Richtung auf die zweiten Kontaktflächen (42) gesehen, eine Gestalt der jeweils zugeordneten dritten Kontaktflächen (53) den zweiten Kontaktflächen (42) von dritter elektrischer Verdrahtungsschicht (5) zu dritter elektrischer Verdrahtungsschicht (5) ähnlicher wird.

3. Halbleiterbauelement (1) nach einem der vorhergehenden Ansprüche,
wobei eine Dicke der Isolationsschichten (61, 62, 63) jeweils höchstens 100 µm ist.

4. Halbleiterbauelement (1) nach einem der vorhergehenden Ansprüche,
wobei eine Gesamtgröße des Halbleiterbauelements (1), in Draufsicht auf die Chipoberseite (20) gesehen, höchstens 130 % einer Größe der Chipoberseite (20) ist, so dass das Halbleiterbauelement (1) den genau einen Halbleiterchip (2) umfasst, wobei eine Gesamtgröße aller zweiten Kontaktflächen (42) zusammen größer ist als die Größe der Chipoberseite (20).

5. Halbleiterbauelement (1) nach einem der vorhergehenden Ansprüche,
wobei
- eine Dicke der elektrischen Verdrahtungsschichten (2, 3, 4) jeweils zwischen 20 µm und 200 µm einschließlich ist und
- die elektrischen Durchkontakte (71, 72, 73) durch jede der Isolationsschichten (61, 62, 63) durchgehen, wobei die Durchkontakte (71, 72, 73) benachbarte der elektrischen Verdrahtungsschichten (3, 4, 5) elektrisch verbinden und ein Durchmesser der elektrischen Durchkontakte (71, 72, 73) jeweils zwischen 20 µm und 200 µm einschließlich ist.

6. Halbleitermodul (10), Folgendes umfassend:
- mindestens ein Halbleiterbauelement (1) nach einem der vorhergehenden Ansprüche und
- einen elektrischen Träger (11),
wobei die zweiten Kontaktflächen (42) mit elektrischen Kontaktflächen (12) des elektrischen Trägers (11) verbunden sind.

7. Verfahren zum Herstellen eines Halbleiterbauelements (1), Folgendes umfassend:
- Bereitstellen eines Halbleiterchips (2), der für Spannungen von mindestens 0,6 kV eingerichtet ist und obere Kontaktflächen (21) an einer Chipoberseite (20) umfasst,
- Aufbringen von Isolationsschichten (61, 62, 65) sowie einer ersten elektrischen Verdrahtungsschicht (3), einer zweiten elektrischen Verdrahtungsschicht (4) und mindestens einer dritten elektrischen Verdrahtungsschicht (5) auf den Halbleiterchip (2), wobei
- das Halbleiterbauelement (1) eine chipgroße Packung ist,
- die erste elektrische Verdrahtungsschicht (3) in elektrischem Kontakt mit den oberen Kontaktflächen (21) ist, die erste Kontaktflächen (31) aufweisen, die den oberen Kontaktflächen (21) elektrisch zugeordnet sind,
- die zweite elektrische Verdrahtungsschicht (4) auf einer Seite der ersten elektrischen Verdrahtungsschicht (3) ist, die von den oberen Kontaktflächen (21) entfernt ist und zweite Kontaktflächen (42) aufweist, die den oberen Kontaktflächen (31) elektrisch zugeordnet sind, wobei die zweiten Kontaktflächen (42) als externe Kontaktflächen eingerichtet sind, und
- die mindestens eine dritte elektrische Verdrahtungsschicht (5) zwischen der ersten elektrischen Verdrahtungsschicht (3) und der zweiten elektrischen Verdrahtungsschicht (4) angeordnet ist und mit diesen elektrisch verbunden ist und dritte Kontaktflächen (53) aufweist,
- der Halbleiterchip (2) ein Metall-Isolator-Leistungsfeldeffekttransistor, MISFET, oder ein Bipolarleistungstransistor mit isoliertem Gate, IGBT, ist,
- die erste, die zweite und die dritte Verdrahtungsschicht (3, 4, 5) jeweils durch eine der Isolationsschichten (61, 62, 63) voneinander getrennt sind, die jeweils aus einem dielektrischen Material angefertigt sind, durch das elektrische Durchkontakte (71, 72, 73) ausgebildet sind,
- eine erste der zweiten Kontaktflächen (42), die verschieden von einer elektrisch zugeordneten der oberen Kontaktflächen geformt ist, in Draufsicht auf die Chipoberseite (20) gesehen, vollständig um eine zweite der zweiten Kontaktflächen (42) herum verläuft, die verschieden von der elektrisch zugeordneten der oberen Kontaktflächen geformt ist, so dass die erste und die zweite der zweiten Kontaktflächen (42) rotationssymmetrisch und/oder punktsymmetrisch angeordnet sind.

## Revendications

1. Dispositif semi-conducteur (1) comprenant :
- une puce semi-conductrice (2) configurée pour des tensions d'au moins 0,6 kV comprenant des zones de contact supérieures (21) sur un côté supérieur de puce (20),
- une première couche de câblage électrique (3) en contact électrique avec les zones de contact supérieures (21) ayant des premières zones de contact (31) assignées électriquement aux zones de contact supérieures (21),
- une deuxième couche de câblage électrique (4) sur un côté de la première couche de câblage électrique (3) distant des zones de contact supérieures (21) et ayant des deuxièmes zones de contact (42) assignées électriquement aux zones de contact supérieures (31), les deuxièmes zones de contact (42) étant configurées comme des zones de contact externe, et
- au moins une troisième couche de câblage électrique (5) située entre et reliée électriquement à la première couche de câblage électrique (3) et la deuxième couche de câblage électrique (4) et ayant des troisièmes zones de contact (53),
dans lequel
- le dispositif semi-conducteur (1) est un boîtier de la taille d'une puce,
- la puce semi-conductrice (2) est un transistor à effet de champ métal-isolant, MISFET, de puissance, ou un transistor bipolaire à grille isolée, IGBT, de puissance,
- les première, deuxième et troisième couches de câblage (3, 4, 5) sont séparées les unes des autres dans chaque cas par une couche d'isolation (61, 62, 63) constituée d'un matériau diélectrique à travers lequel des contacts électriques traversants (71, 72, 73) sont formés,
- une première des deuxièmes zones de contact (42) façonnée différemment d'une zone assignée électriquement parmi les zones de contact supérieures chemine entièrement autour d'une deuxième des deuxièmes zones de contact (42) façonnée différemment de la zone assignée électriquement parmi les zones de contact supérieures d'une manière coaxiale, observée dans une vue de dessus du côté supérieur de puce (20), de telle sorte que la première et la deuxième des deuxièmes zones de contact (42) sont disposées avec une symétrie en rotation et/ou une symétrie ponctuelle.

2. Dispositif semi-conducteur (1) selon la revendication précédente,
comprenant au moins deux des troisièmes couches de câblage électrique (5) situées entre et reliées électriquement à la première couche de câblage électrique (3) et la deuxième couche de câblage électrique (4), respectivement,
dans lequel, en regardant depuis les premières zones de contact (31) et vers les deuxièmes zones de contact (42), une forme des troisièmes zones de contact (53) respectivement assignées devient plus similaire à celle des deuxièmes zones de contact (42) en allant d'une troisième couche de câblage électrique (5) à une troisième couche de câblage électrique (5).

3. Dispositif semi-conducteur (1) selon l'une quelconque des revendications précédentes,
dans lequel une épaisseur des couches d'isolation (61, 62, 63) est dans chaque cas au maximum de 100 µm.

4. Dispositif semi-conducteur (1) selon l'une quelconque des revendications précédentes,
une taille globale du dispositif semi-conducteur (1) représentant au maximum 130 % d'une taille du côté supérieur de puce (20), observée dans une vue de dessus du côté supérieur de puce (20), et de telle sorte que le dispositif semi-conducteur (1) comprend exactement la puce semi-conductrice (2), dans lequel une taille globale de la totalité des deuxièmes zones de contact (42) est dans son ensemble plus grande que la taille du côté supérieur de puce (20).

5. Dispositif semi-conducteur (1) selon l'une quelconque des revendications précédentes,
dans lequel
- une épaisseur des couches de câblage électrique (2, 3, 4) se situe dans chaque cas entre 20 µm et 200 µm inclus, et
- les contacts électriques traversants (71, 72, 73) cheminent à travers chacune des couches d'isolation (61, 62, 63), les contacts traversants (71, 72, 73) relient électriquement des couches de câblage électrique (3, 4, 5) qui sont adjacentes, et un diamètre des contacts électriques traversants (71, 72, 73) se situe dans chaque cas entre 20 µm et 200 µm inclus.

6. Module semi-conducteur (10) comprenant
- au moins un dispositif semi-conducteur (1) selon l'une quelconque des revendications précédentes, et
- un support électrique (11),
dans lequel les deuxièmes zones de contact (42) sont reliées à des faces de contact électrique (12) du support électrique (11) .

7. Procédé de fabrication d'un dispositif semi-conducteur (1) comprenant
- l'obtention d'une puce semi-conductrice (2) configurée pour des tensions d'au moins 0,6 kV comprenant des zones de contact supérieures (21) sur un côté supérieur de puce (20),
- l'application de couches d'isolation (61, 62, 65) ainsi que d'une première couche de câblage électrique (3), d'une deuxième couche de câblage électrique (4) et d'au moins une troisième couche de câblage électrique (5) sur la puce semi-conductrice (2),
dans lequel
- le dispositif semi-conducteur (1) est un boîtier de la taille d'une puce,
- la première couche de câblage électrique (3) est en contact électrique avec les zones de contact supérieures (21), ayant des premières zones de contact (31) assignées électriquement aux zones de contact supérieures (21),
- la deuxième couche de câblage électrique (4) est sur un côté de la première couche de câblage électrique (3) distant des zones de contact supérieures (21) et a des deuxièmes zones de contact (42) assignées électriquement aux zones de contact supérieures (31), les deuxièmes zones de contact (42) sont configurées comme des zones de contact externes,
- l'au moins une troisième couche de câblage électrique (5) est située entre et reliée électriquement à la première couche de câblage électrique (3) et la deuxième couche de câblage électrique (4) et a des troisièmes zones de contact (53),
- la puce semi-conductrice (2) est un transistor à effet de champ métal-isolant, MISFET, de puissance, ou un transistor bipolaire à grille isolée, IGBT, de puissance,
- les première, deuxième et troisième couches de câblage (3, 4, 5) sont séparées les unes des autres dans chaque cas par une des couches d'isolation (61, 62, 63) constituées chacune d'un matériau diélectrique à travers lequel des contacts électriques traversants (71, 72, 73) sont formés,
- une première des deuxièmes zones de contact (42) façonnée différemment d'une zone assignée électriquement parmi les zones de contact supérieures chemine entièrement autour d'une deuxième des deuxièmes zones de contact (42) façonnée différemment de la zone assignée électriquement parmi les zones de contact supérieures, observée dans une vue de dessus du côté supérieur de puce (20), de telle sorte que la première et la deuxième des deuxièmes zones de contact (42) sont disposées avec une symétrie en rotation et/ou une symétrie ponctuelle.
